# EUROPEAN PATENT APPLICATION

(11) **EP 2 806 572 A1**
(43) Date of publication of application: **26.11.2014**
(21) Application number: 14159233.7
(22) Date of filing: 12.03.2014
(51) Int. Cl.: H04B 3/54, G06Q 10/04, G01R 31/08

(54) **Detecting and locating power outages via low voltage grid mapping**

(30) Priority: 15.03.2013 US 201313842676
(71) Applicant: Echelon Corporation, San Jose, CA 95126 (US)
(72) Inventor: Riley, Glen M., Saratoga, CA California 95070 (US); Sutterlin, Philip H., Saratoga, CA California 95070 (US); Dolin Jr., Robert A., Menlo Park, CA California 94025 (US); DeMoney, David W., San Francisco, CA California 94107 (US); Vergani, Roberto, 20146 Milan (IT)
(74) Representative: Giles, Ashley Simon

(57) **Abstract**

In a power grid capable of electrical power delivery and power line communications, a distribution transformer and at least one smart meter is connected to the power grid. In one embodiment, the distribution transformer is configured to map the smart meters on the power grid to a virtual grid based upon measurements of signal metrics received from the various smart meters on the power grid, and the virtual grid is used to determine if a failure has occurred on the physical grid. A communications failure between nodes on the grid suggests a possible power failure, and the failure can be located using mapping information obtained from the virtual grid. A drop in power consumption on the power grid corroborates outages detected via the communications failure. In one embodiment, a cross phase delta value is computed to adjust the signal strength metrics measured between nodes having differing phases of electrical distribution.

## Description

### FIELD OF THE INVENTION

This invention relates generally to networks having a plurality of nodes, and in particular to the detection of a power failure over of power line networks via low voltage grid mapping.

### DESCRIPTION OF THE RELATED ART

For power line networks over which power line communication is enabled, one means for detecting current power outages in a power grid is by inferring them from the failure of power line communications. This approach, however, is prone to false positives; a system can experience a communication failure for reasons other than a power outage, such as communication impairments caused by power consuming devices. For example, power-consuming devices could be metered residential devices, metered commercial devices, or non-metered devices such as streetlights. It is the nature of such impairments that they come and go as devices are powered on or off, or otherwise vary their behavior as demands on the devices change. In order for outage detection to be made useful, the percentage of false positives must be low enough to make the information reliable.

### SUMMARY OF THE DESCRIPTION

In a power grid capable of electrical power delivery and power line communications, a distribution transformer and at least one smart meter is connected to the power grid. One embodiment of the smart meter contains a smart meter module, a signal measurement module, and a communications module. One embodiment of the distribution transformer has a power meter module, a signal strength measurement module, a power line communications module, and an analysis module. In one embodiment, the distribution transformer is configured to map the smart meters on the power grid to a virtual grid based upon measurements of signal metrics received from the various smart meters on the power grid. The virtual grid can then be used to determine if a failure has occurred on the physical grid, based upon information from the analysis module, and the failure is located using mapping information obtained from the virtual grid. In one embodiment, a cross phase delta value is computed to adjust the signal strength metrics measured between nodes having differing phases of electrical distribution.

### BRIEF DESCRIPTION OF THE DRAWINGS

A better understanding of the present invention can be obtained from the following detailed description in conjunction with the following drawings, in which:
FIG. 1 illustrates a network architecture for implementing various embodiments of the invention;
FIG. 2 depicts a graphical representation of a network in which a master node communicates with edge nodes and intermediate points on a virtual grid;
FIG. 3 illustrates one embodiment of a method of generating virtual line lengths;
FIG. 4 illustrates one embodiment of a method of calculating signal strength values for points on the virtual network using measured signal strength values between nodes on the network;
FIG. 5 illustrates one embodiment of a method for combining graphical representations of a physical network grid and statistical analysis of grid metrics to detect and locate failures;
FIG. 6 is a graphical representation of a virtual grid, which is used to map a group of smart electrical meters on a power distribution grid;
FIG. 7A illustrates an example distribution transformer and smart meter grid in which meters are collocated in a meter room;
FIG. 7B illustrates a virtual representation of a virtual grid according to one embodiment of the invention;
FIG. 8 illustrates an example electrical power distribution grid over which power line communication is enabled according to one embodiment of the invention;
FIG. 9 is a block diagram of a distribution transformer according to one embodiment of the invention; and
FIG. 10 is a block diagram of a smart meter according to one embodiment of the invention.

### DETAILED DESCRIPTION

In the following description, for the purposes of explanation, numerous specific details are set forth in order to provide a thorough understanding of various embodiments of the invention. It will be apparent, however, to one skilled in the art that the embodiments of the invention can be practiced without some of these specific details. Moreover, in some instances, well-known structures and devices are shown in block diagram form to avoid obscuring the underlying principles of the invention.

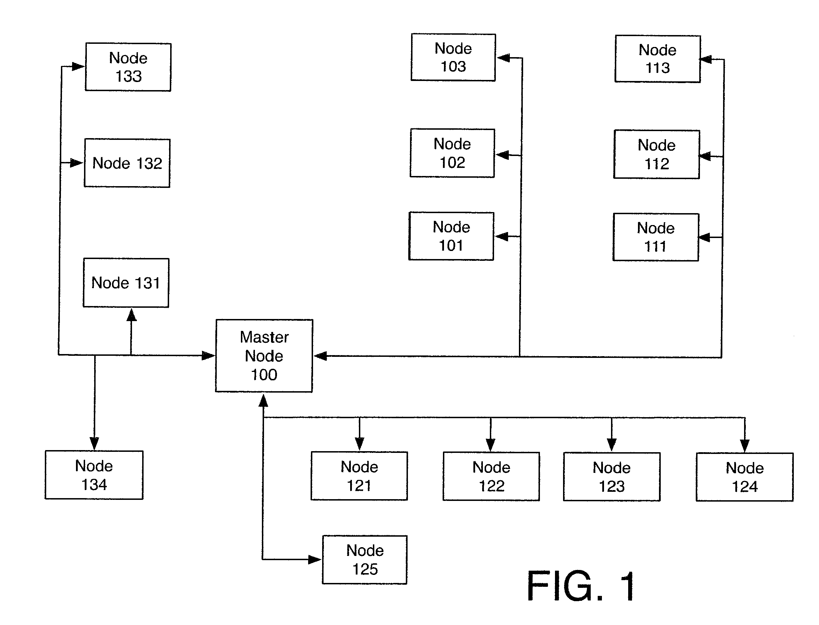

**FIG. 1** generally depicts a network over which a plurality of nodes 100, 101-103, 111-113, 121-125, and 131-134 communicate. In one embodiment, each of the nodes is comprised of a processor (e.g., a microcontroller or a micro-processor) and memory. In addition, each node is configured to store, process and communicate (internally or with other nodes) instructions and data using non-transitory machine-readable media such as magnetic disks, random access memory ("RAM"), read only memory ("ROM"), etc. Moreover, while particular embodiments of the invention are implemented in software via instructions stored on machine-readable media, alternative embodiments implement the functions described herein using any combination of software and hardware.

In one embodiment, the nodes 100, 101-103, 111-113, 121-125 and 131-134 form a distributed control network. In this embodiment, each of the nodes 100, 101-103, 111-113, 121-125, and 131-134 are programmed to perform a specific task. For example, individual nodes are configured as proximity sensors, switches, motion detectors, relays, motor drives, and/or other types of instruments (e.g., utility meters). The individual nodes of this embodiment are programmed to work together as a whole to perform a complex control application such as running a manufacturing line or automating a building. It should be noted, however, that the underlying principles of the invention are not limited to any particular type of node or any particular network configuration or application.

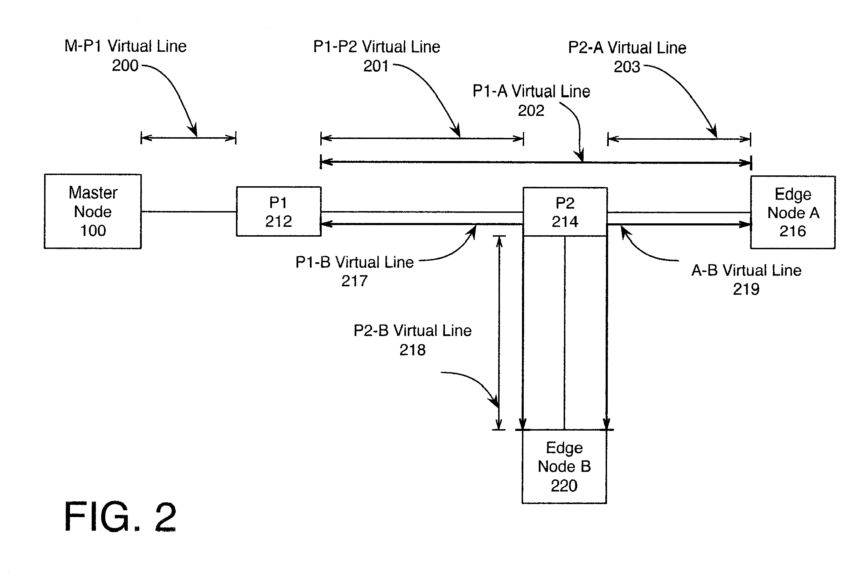

**FIG. 2** depicts a network in which a master node 100 communicates with an edge node A 216, an edge node B 220, and intermediate points 212 and 214. In one embodiment, the network is a virtual network in which the distance between points and nodes on the network represents one or more relational metrics associated with the nodes and points on the network. In one embodiment, the lines on the virtual network represent one or more signal strength measurements between the master node 100, one or more edge nodes 216, 220, and one or more intermediate points (e.g. P1212 and P2 214) on the network. In one embodiment, the virtual network represents a physical network that is used for electrical power distribution, over which power line communication is enabled. In a power distribution network configured for power line communication, one mechanism for determining the quality of the relationship between nodes and points on the network is a signal strength measurement. In one embodiment, each node 216, 220 includes the ability to measure signal strength, and classify the signal strength as an abstract metric. For example, in one embodiment, a signal strength measurement is represented as a numerical range from 0 to 15, where zero is the strongest measure and fifteen is the weakest. Generally, it is presumed that a lower signal strength measurement, and thus, a higher numerical value, linearly correlates to the physical line distance between points (e.g. 212, 214) and nodes (e.g. 216, 220) on a physical network, though there are other factors that can affect signal strength between network elements which are not directly related to distance.

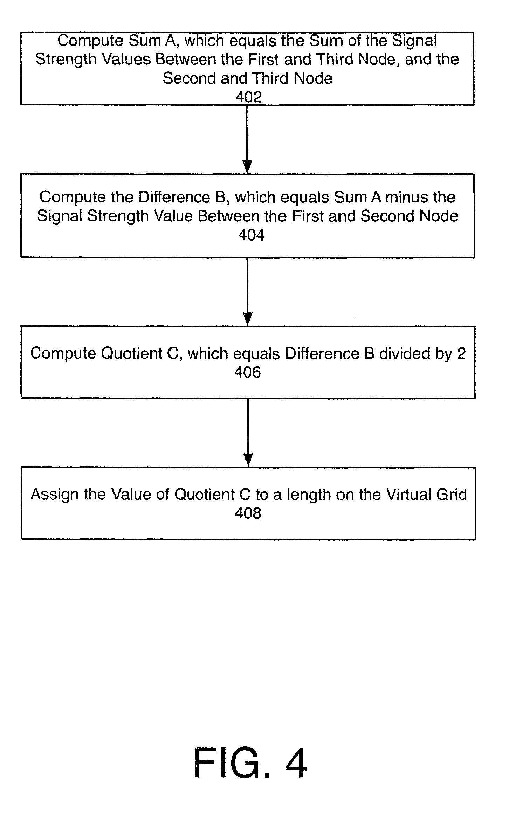

Notwithstanding other factors that can impact signal strength measurements, a presumed line-length to signal strength relationship is used to represent network elements on a virtual grid, as demonstrated in **FIG. 2****.** For example, an M-P1 virtual line 200 on the virtual grid has a virtual line length, which represents one or more signal strength measurements between the master node 100, and a first point on the network, P1 212. Additionally, the length of a P1-P2 virtual line 201 represents the signal strength between P1 212 and a second point on the network, P2 214. The lengths of a P2-A virtual line 203, and a P2-B virtual line 218 represent additional signal strength values between P2 214 and Edge Node A 216, and P2 214 and Edge Node B 220 respectively. In one embodiment, when the signal values between certain nodes and connection points are not derivable from direct measurements, the values are calculated using the virtual line lengths of related nodes on the virtual grid. For example, in the event the lengths of virtual line P2-B 218 is not determinable from direct measurements, the length is derived from virtual lines that represent signal measurements from related or interconnected nodes. For example, using an embodiment of a method described below, and illustrated in FIG. 4, the length of the P2-B virtual line can be determined from the lengths of a P1-A 202 virtual line, and a P1-B virtual line 217, and an A-B virtual line 219.

Additionally, special values are used to indicate additional information on the virtual grid. For example, a special value (e.g., 16) is used to indicate a "no path" relationship between network elements, while an additional special value (e.g., 17) is used to indicate that the relationship between elements is "unknown." A "no path" value arises if the signal strength between elements is too low for one element to communicate with the other element, while an "unknown" value indicates that no attempt to communicate has been made between two mapped network elements.

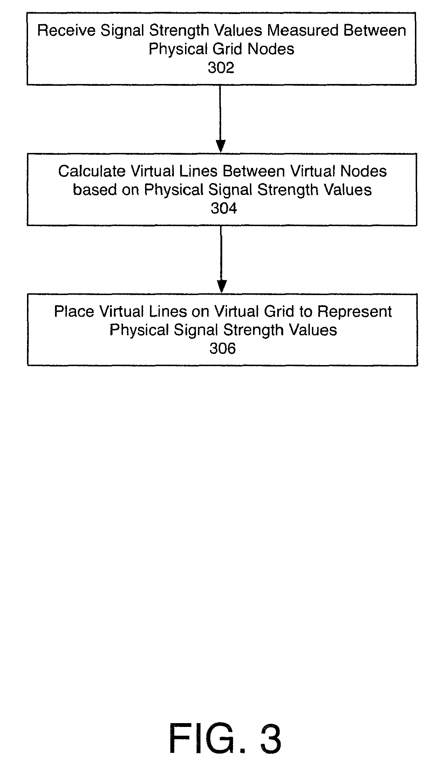

**FIG. 3** illustrates one embodiment of a method of generating virtual line lengths. In 302, signal strength values measured between nodes on the physical grid are gathered. In one embodiment, each node measures and transmits signal strength data to a master node (e.g. master node 100), which in 304 calculates virtual line lengths between virtual nodes on the graphical representation of the physical network. In 306, those virtual lines, with their associated virtual line lengths, are placed on the virtual grid to represent the signal strength measurements gathered between the network elements of the physical grid. Characteristics of the virtual lines are not limited to length, and the signal metric illustrated is not limited to signal strength. In one embodiment, virtual line width is used to represent a different signal metric, such as signal to noise ratio. Therefore, it is to be understood that examples demonstrating one particular metric to line characteristic coupling are intended to be illustrative, and non-limiting in their nature.

In one embodiment, a virtual network has points along grid lines such as P1 212 and P2 214 of **FIG. 2**, which represent points on the network for which no active signal strength measurement is available. In such embodiment, the master node 100 uses analysis modules to calculate the signal strength between such points based on available signal strength measurements on the virtual grid. For example, given a signal strength measurement between a first node and a third node on the virtual grid, a signal strength measurement between a second node and the third node on the virtual grid, and a signal strength measurement between a first node and a second node on the virtual grid, a signal strength measurement for a common point on the grid that connects the three nodes is calculated.

**FIG. 4** illustrates one embodiment of a method used to calculated signal strength values for points on the virtual network using measured signal strength values between nodes on the network. While, in one embodiment, the virtual network is used to calculate the signal strength values for points on the virtual network, the specific use of the virtual network is not a limiting factor of the invention. In one embodiment, the calculations used to generate the virtual network are directly analyzed to calculate signal strength values on the network. For illustrative purposes, however, the virtual network is used to illustrate the concepts. In one embodiment, in 402, Sum A is computed, which equals the sum of the signal strength value measured between the first and third node, and the signal strength value measured between the second and third node. A single value measurement is used in each instance, or an average value, or some normalized or adjusted value is used. In one embodiment, a running average signal strength measurement is used to update the virtual network over time. In 404, Difference B is computed, which equals the difference between Sum A and one or more signal strength measurements between the first node and the second node. In 406, Quotient C is computed, which equals one half of Difference B. In 408 the value of Quotient C is assigned to the length of the line on the virtual grid, which represents the signal strength between the third node and a connecting point on the grid common to the three nodes.

Returning to **FIG. 2**, this method is used to calculate the length of the P2-B virtual line length 218 between P2 214 and edge node B 220. For example purposes, assume P1212 is a network repeater on a physical power distribution grid with power line networking enabled, and P2 214 is an intermediate connecting point for P1 212, edge node A 216, and edge node B 220 on the physical power distribution grid. In this example, the signal strength between P1 212 and edge node B 220 is measurable and represented by the P1-B virtual line 217. The signal strength between edge node A 216 and edge node B 220 is measureable and represented by the A-B virtual line 219. Additionally, the signal strength between P1 212 and edge node A 216 is measureable and represented by the P1-A virtual line 202. In this example, one embodiment of the method illustrated in FIG. 4 calculates the virtual line length representing the signal strength value, or other signal metric, between P2 214 and edge node B 220 using the following formula: P2B = (P1B + AB - P1A) ÷ 2. This value can then be used to represent the P2-B virtual line length 218.

The measured and calculated signal strength values are combined with statistical and historical analysis to generate a graphical representation of a physical network, which is then used to accurately detect network failures, and locate points of failure. When such method is applied to a power distribution network configured for network communication over the power lines, power failures are detected faster and more accurately than using signal strength measurements or communication failures alone.

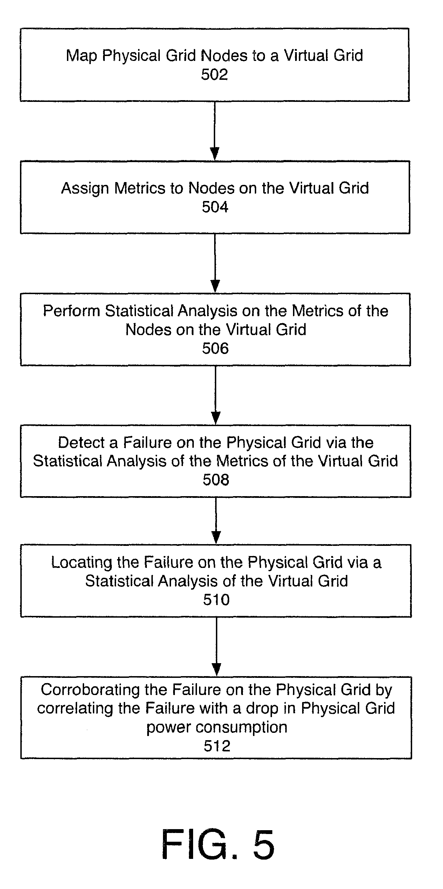

**FIG. 5** illustrates one embodiment of a method for combining graphical representations of a physical network grid and statistical analysis of grid metrics to detect and locate failures. In one embodiment, at 502, the networked elements on the physical grid are mapped to a virtual grid, which includes virtual representations of the various physical network elements. Metrics are gathered and assigned, in 504, to the various nodes on the physical grid. In one embodiment, multiple sets of metrics are assigned to the various nodes for use in grid in analysis. Once a communication failure is detected on the virtual grid, these additional metrics are analyzed at 506 to determine if the communication failure detected is the result of a line failure over the power distribution lines over which the network elements communicate, or if the communication failure is the result of factors other than a power line failure. Examples of such metrics include signal margin, which is the measure of the signal strength between network elements relative to the line noise of the network. The higher the signal margin, the less likely that a communication failure between network elements is due to impairments caused by network noise generators, which can cause communication losses via the introduction of line noise.

In one embodiment, the analysis also includes an historical analysis, which takes into account the margin between the historically most reliable network elements and a potential point of line failure. For example, signal margin is ordinarily cyclical throughout a twenty-four hour day. However, if the margin is seen as continuously degrading throughout the day, this can be an indication of a cable degradation that can lead to an electrical outage if not addressed. In one instance, continuous margin degradation at a specific building or residence can indicate the impending failure of an electrical feeder cable from the distribution network. A margin measurement from each point on the distribution network can help to isolate where the feeder problem is before there an electrical outage occurs.

In one embodiment, the result of the statistical analysis in 506 is graphically represented on the virtual grid to facilitate the detection of a power failure event on the physical grid. Once a power line failure is detected, the precise location of the failure may not be immediately evident. In one embodiment, in 510, multiple factors are used to determine the location of a power line failure on the grid once a line failure has been detected. Factors considered include, the failure history of various elements on the grid. Impairments that occur due to powered devices on the power grid can sometimes be repetitive in nature. If a powered device has a history of causing communication failures with certain elements on the power line communications network, then that factor is considered when evaluating whether a communication failure is a false positive for a power line failure. Additionally, the pattern of certain failures is considered. For example, if a particular network element is known to suffer communication failures daily, for example, between 5:00 pm and 8:00 pm, then a communication failure during that time is considered to be a likely false positive. Communication failures outside that time range, however, are treated as indicative of an actual power outage. Additionally, in one embodiment, communication failures to network elements that are known to have repeated communication failures without power line failures are considered more likely to be false positives relative to network elements with no history of communication failure.

A more straightforward scenario for analysis in 510 is the case of multiple concurrent failures. If multiple failures occur that all suggest a specific point of failure, then statistically the odds increase that the communication failures are due to power line outages. For example, if all elements on the virtual grid that are located on the far side of a specific virtual point on the network, and all elements are reporting communication failures, then statistically it is significantly more likely than not that the line failure is at, near, or related to the specific virtual point. On the other hand, if some of the network elements are still in communication with the rest of the network, then the statistical likelihood is significantly reduced.

In one embodiment, energy consumption metrics are used to determine or predict a power outage. For example, if a statistically significant number of nodes lose power, then there will be a noticeable impact on the total energy use measured on the network. As shown at 512, the master node 100 can detect a loss of communication on the network, and correlate the loss of communication with a corresponding drop in energy usage. The correlation enhances the probability that the loss of communication is caused by an actual power outage. One aspect of the analysis would be to examine the energy usage trends over time to establish a comparison baseline. It is to be understood that the list of metrics discussed above is a nonexclusive list, and other metrics are possible, some of which are discussed below.

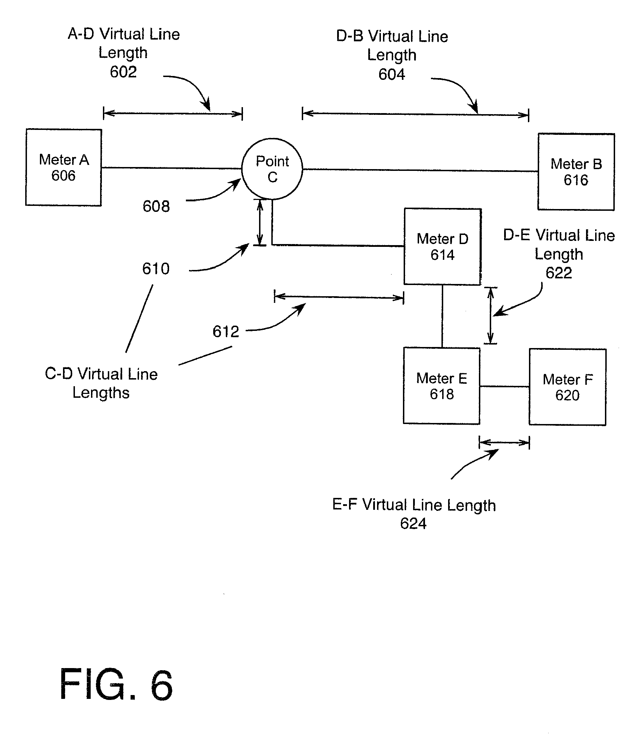

**FIG. 6** is a graphical representation of a virtual grid in which one embodiment of the method of **FIG. 4** is used to map a group of smart electrical meters on a power distribution grid. Illustrated are smart meters A 606, B 616, D 614, E 618, and F 620, which are arranged on a virtual grid, connected by virtual lines, each having a virtual line length, which serve as indicators of signal strength, or some other signal metric. The virtual lines, 602, 604, 608, 610, 622, and 624 are measured by the smart meters, as in the case of the A-D virtual line 602 and D-B virtual line 604, or are calculated by one or more analysis modules attached to the virtual grid, such as in the case of the C-D virtual lines, 610 and 612, which represent the signal between point C 608 and meter D 614. Some indicators are adjusted via a combination of measurement and calculation, such as, for example, virtual lines 622 and 624. In one embodiment, the analysis modules that analyze the signal metrics between nodes are stored in one or more distribution transformers located on the network, however, the analysis modules are not limited in such a manner, and multiple nodes on the grid are capable of signal metric calculations.

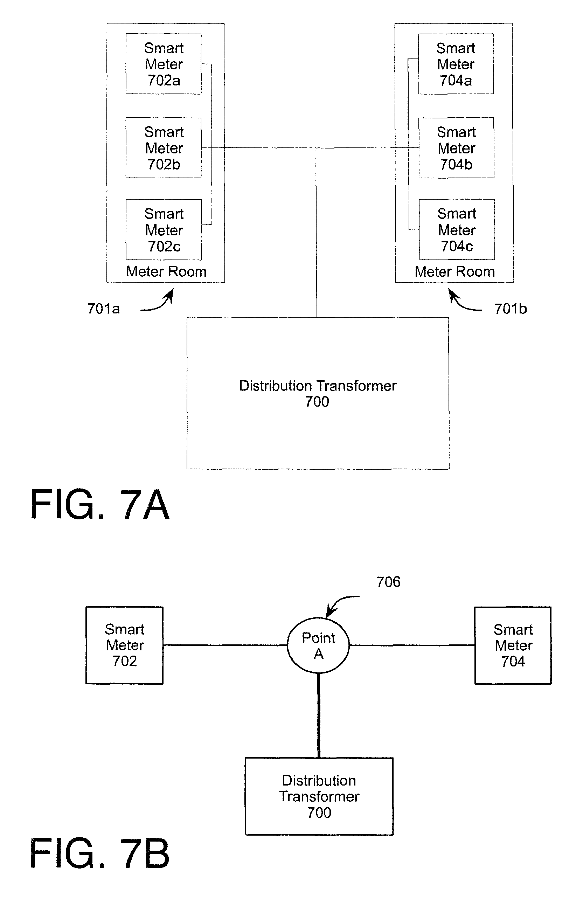

**FIG. 7A** illustrates an example distribution transformer and smart meter grid in which meters are collocated in a meter room. In this figure and figures to follow, like reference numerals are used to identify like elements. A letter after a reference numeral, such as "702a," indicates that the text refers specifically to the element having that particular reference numeral. A reference numeral in the text without a following letter, such as "702," refers to any or all of the elements in the figures bearing that reference numeral.

As measurements are made, meters will be found, such as meters 702 and 704 that are measured, based on signal strength, or some other metric linearly related to distance, to be essentially at the same place physically. This scenario can occur when meters are in a meter room 701 a, 701 b where a several meters are collocated, such as in a commercial office building. This can provide a means of grid visualization optimization, as measurement are taken relative to one meter in the collection of collocated meters. The precise value of the signal metric that indicates collocation can vary. In one embodiment, a typical minimum measurement of distance via, for example, signal strength, is a value of one, because of losses occurring in the coupling circuits and the distance, however short, between meters collocated meters, even if the highest possible signal strength used in the signal strength scale is zero. In one embodiment, a default minimum value (and this maximum signal strength) is used to determine collocation, and that value is adjusted as needed. The physical grid arrangement of the distribution transformer 700 and the meters housed in meter room 701a and 701b is illustrated in **FIG. 7B**.

**FIG. 7B** illustrates a virtual representation of the physical grid in **FIG. 7A** according to one embodiment of the invention. In one embodiment, each smart meter 702a, 702b, 702c housed in the meter room 701 a of **FIG. 7A** is illustrated as a single meter 702, and each smart meter 704a, 704b, and 704c housed in meter room 701 b is illustrated as a single meter 704. A connecting point A 706 can illustrate the common junction between meters 702, 704, and the distribution transformer 700. If point A is not capable of gathering direct signal metrics, those metrics are calculated via analysis as discussed above.

In one embodiment, the virtual grid does not wait for all data to be collected before computing a graph, and a best estimate of the graph is computed and then refined over time. Accordingly, connections are split and re-joined, as the virtual grid is refined based on new data. Virtual grid topologies can change radically as switches are thrown in the network and other modifications are made in the wiring of the physical power distribution grid represented by the virtual grid. Thus, the grid calculation and data gathering is a constant process that updates and evolves over time. This evolving nature makes the virtual grid useful for detecting, locating, and rapidly resolving power outages on the physical grid.

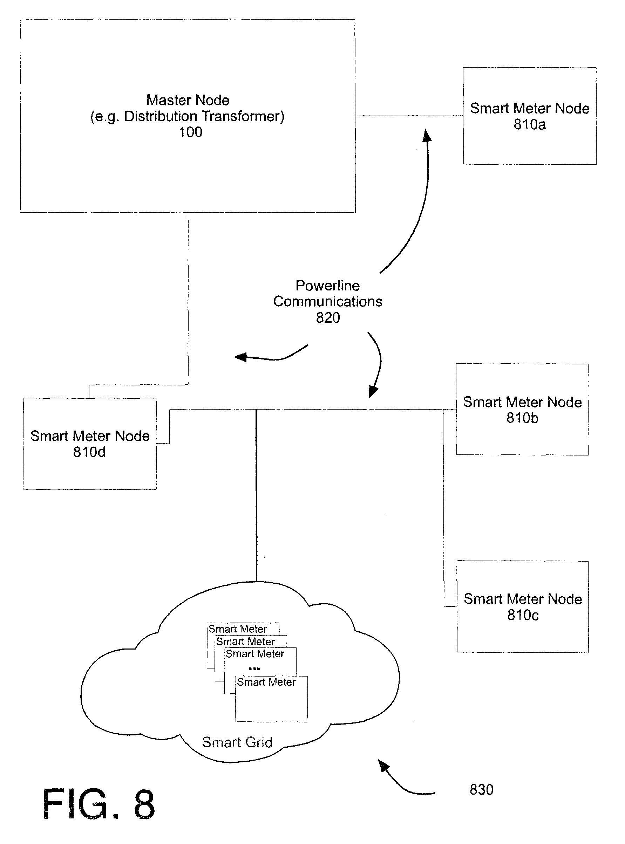

**FIG. 8** illustrates an example electrical power distribution grid over which power line communication is enabled, which is a specific example of one embodiment of the network illustrated in **FIG. 1**. In one embodiment, the master node 100 is a distribution transformer, such as the distribution transformer 700 in **FIG. 7**, which is connected to multiple smart meter nodes 810 over a power distribution grid in which power line communications 820 are enabled. The master node 100 is also connected to a larger smart grid 830, containing numerous smart meters. A distribution transformer serving as a master node 100 can house various analysis modules, which use various measurements and analysis techniques to detect and locate power failures using virtual grid mapping techniques, historical and statistical analysis.

For example, if smart meter node 810c is attached to a residential building to measure power consumption, a communication link is maintained between smart meter 810c and the distribution transformer master node 800. If a communications failure were to occur at the residence due to the introduction of noise from a power-consuming device in the residence, the impact on the communications grid is generally greatest at the meter node 810c attached to the residence. The typical impact is that the meter 810c will no longer be able to receive messages due to the line noise; however, the meter's ability to transmit messages may not be impacted. For example, if the master node 100 attempts to communicate with meter node 810c and there is impairment due to noise generation on the load side (e.g. inside the power system of the residential building), then node 810c may be unable to receive communications from the master node 100 while the master node 100 can still receive transmissions from the smart meter 810c. In one embodiment of the smart meter node 810, each meter tracks whether it was in communication with an agent, such as a distribution transformer, or some other master node 100. If the smart meter 810 is unable to communicate to the master node 100 for a period of time, but the power delivery grid is functioning normally, the meter will send an unsolicited message to the agent indicating that it was still powered. The agent will then make this information available on the virtual grid to indicate that even though the node is out of communication, a power failure has not occurred.

In one embodiment of the smart meter node 810, contains a battery as a backup power supply, and a "last gasp" message is sent when a power failure is detected. While this message cannot be depended on to be received due to the potentially unreliable nature of the power grid during a power distribution failure, receiving such a message gives a high degree of probability that a power failure has occurred. Smart meters can also be equipped with noise detection modules to detect the amount of noise on the communication line. A communications failure to a smart meter node 810 that is currently experiencing a large amount of line noise can indicate that the communication failure is for reasons other than a power failure. In one embodiment, factors external to the power distribution grid, such as an impending storm, or other weather patterns, or geological events, are analyzed, such that certain external factors can indicate that a system power grid failure is more likely to occur than otherwise.

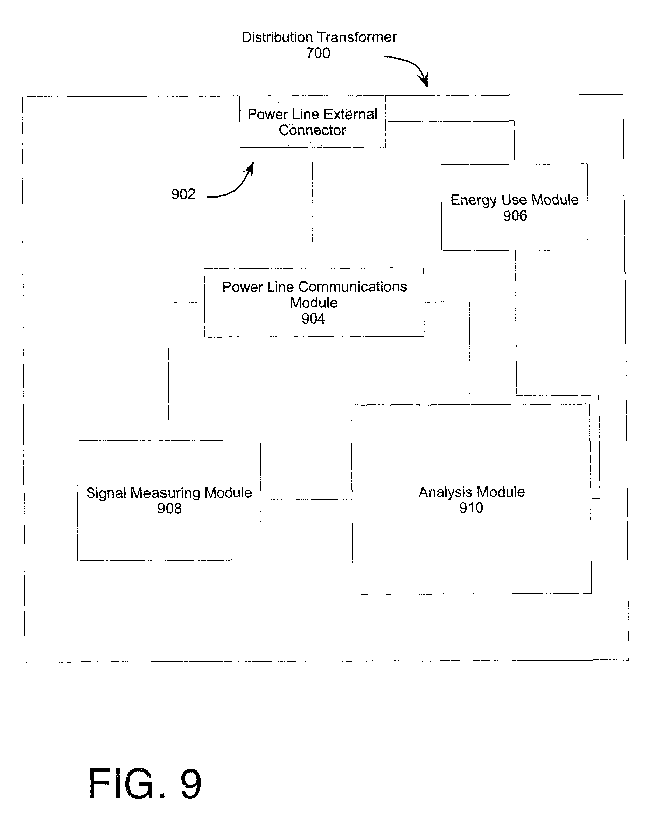

**FIG. 9** is a block diagram of a distribution transformer according to one embodiment of the invention. In one embodiment, a distribution transformer, such as the distribution transformer 700 of **FIG. 7**, contains a power line external connector 902 to connect to the power distribution grid, an energy use module 906 to measure grid energy use. The distribution transformer 700 contains a power line communications module 904 to enable network communication over the power grid, and a signal-measuring module 908, which can measure signal strength, signal margin, or other signal metrics. In one embodiment, an analysis module 910 is present, which performs multiple methods of statistical analysis on data available to the transformer. In one embodiment, the analysis module contains hardware and software to perform event analysis, signal margin analysis, and store historical data on the grid performance. While the analysis module 910 is illustrated as a component of the distribution transformer 700, a data concentrator module (not shown), such as a data control node, which is separate from the distribution transfonner 700, but otherwise coupled to the grid, can include one or more analysis modules 910, to discover and map grid topology.

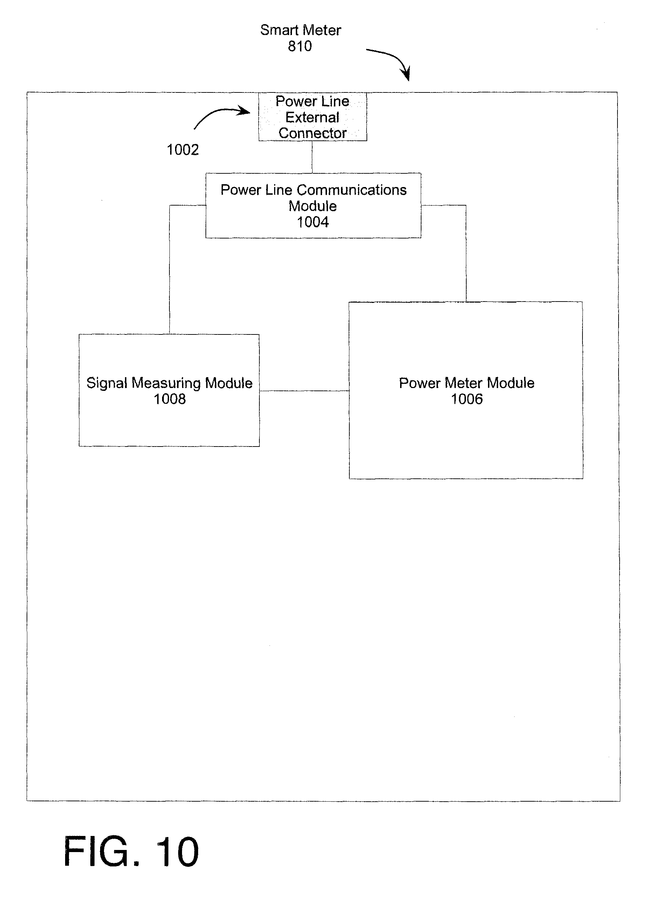

**FIG. 10** is a block diagram of a smart meter according to one embodiment of the invention. In one embodiment, a smart meter, such as the smart meter 810 of **FIG. 8**, contains a power line external connector 1002 to connect to the power distribution grid, a power meter module 1008 to meter power consumption at the meter location on the power grid. The smart meter 810 contains a power line communications module 1004 to enable network communication over the power grid, and a signal-measuring module 1008, which can measure signal strength, signal margin, or other signal metrics.

When measuring signal strength on power distribution grids utilizing three phase alternating current distribution, measurements between two smart meters, or a smart meter and a distribution transformer that are on different phases can be less than the equivalent pair of meters on the same phase. The difference cause by a phase differential is the Cross-Phase Delta (CPD), and can vary from utility to utility, from transformer to transformer, and from electrical feeder to electrical feeder. To account for these differences, an embodiment of the grid mapping system iterates through all possible CPD values (0 to 15, which corresponds to the total range of the signal strength measurements) for all of the meters on a single feeder until a valid result is obtained.

Validation of the CPD is dependent upon the ability to record unimpaired readings, either from a distribution transformer or between smart meters having the same phase. The raw and unimpaired readings are used to validate the adjustment used for meters on different phases. Without unimpaired readings, any CPD value will appear to be valid, and a default configured CPD will be used.

Additionally, since the distribution transformer communicates on all 3 phases, it acts as a coupler between the phases, which reduces the effect of the CPD for nearby meters. For the purposes of grid mapping, this effect is assumed to be linear, decaying from 12dB to 0dB over a distance of 15 units. While each feeder can have a different CPD, it is assumed that the CPD for each node on a single feed is equal.

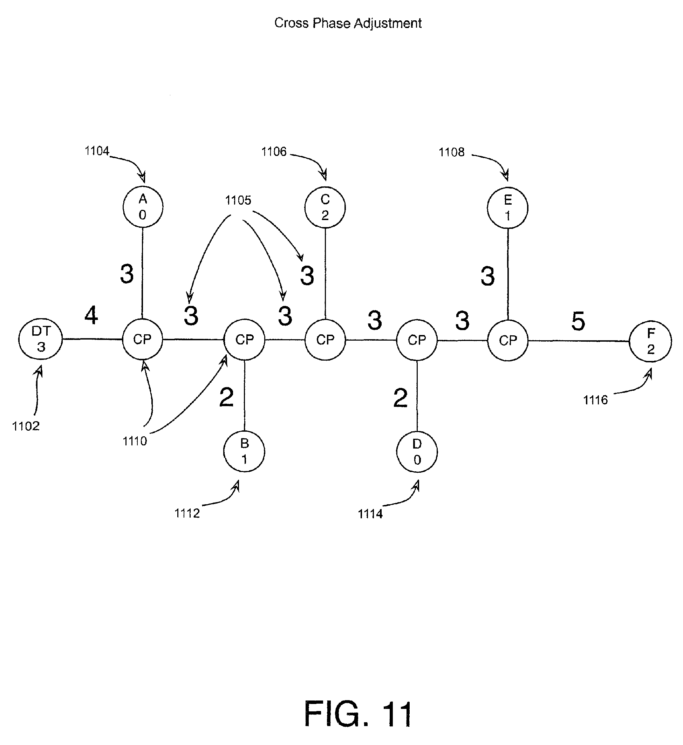

Figure 11 is an illustration of grid map in which distance calculations between nodes are adjusted due to the cross phase delta, according to an embodiment. In this example, the numbers on the connecting lines (e.g., 1105) represent the actual line distance between each pair of points. A distribution transformer (DT) 1102, which is an embodiment of the distribution transformer 700, couples with all phases of distribution. Each node distributes power in successive phases, such that node A 1104 is at phase 0, node B 1112 is at phase 1, and node C 1106 is at phase 2. Likewise, node D 1114 is at phase 0, node E 1108 is at phase 1, and node F 1116 is at phase 3.

Table 1 below is a table of the actual line distances between each node as indicated in Figure 11.

**Table 1: Actual Line Distances**

| **Device** | **DT** | **A** | **B** | **C** | **D** | **E** | **F** |
|---|---|---|---|---|---|---|---|
| **DT** | NA | | | | | | |
| **A** | 7.0 | NA | | | | | |
| **B** | 9.0 | 8.0 | NA | | | | |
| **C** | 13.0 | 12.0 | 8.0 | NA | | | |
| **D** | 15.0 | 14.0 | 10.0 | 8.0 | NA | | |
| **E** | 19.0 | 18.0 | 14.0 | 12.0 | 8.0 | NA | |
| **F** | 21.0 | 20.0 | 16.0 | 14.0 | 10.0 | 8.0 | NA |

The measured signal strength values of the grid are determined by data from the signal measuring modules in each node (e.g., signal measuring module 1008 of smart meter 810 in Figure 10 and signal measuring module 908 of distribution transformer 700). An analysis module (e.g., analysis module 910 of Figure 9) analyzes signal data to construct a virtual grid.

Figure 2 below is a table of example signal strength values measured from a physical grid corresponding to the illustration in Figure 11. The value at the intersection of two nodes indicates the measured signal value. In the table below, an empty cell indicates that a signal strength value cannot be read because the relative line distance between the two nodes is too large.

**Table 2: Measured Signal Strength**

| **Device** | **DT** | **A** | **B** | **C** | **D** | **E** | **F** |
|---|---|---|---|---|---|---|---|
| **DT** | **NA** | | | | | | |
| **A** | 8 | NA | | | | | |
| **B** | 6 | 5 | NA | | | | |
| **C** | 2 | 1 | 5 | NA | | | |
| **D** | 0 | 1 | 3 | 5 | NA | | |
| **E** | | | | 1 | 5 | NA | |
| **F** | | | | 1 | 3 | 5 | NA |

As shown in Figure 11, each node is coupled to the distribution feed via a cross phase (CP) junction (e.g., 1110). In this example, it is assumed that the CPD for each CP is the same. It will again be noted that signal strength measurements inversely correlate to physical line distances between nodes, such that a low signal measurement, such as the 0 measurement between node D1114 and the distribution transformer 1102, indicates a large distance.

Presuming a CPD value of 0, an analysis module in the distribution transformer 1102 will compute the set of distance values shown in Table 2.

**Table 2: Computed Distances (CPD Value 0)**

| **Device** | **DT** | **A** | **B** | **C** | **D** | **E** | **F** |
|---|---|---|---|---|---|---|---|
| **DT** | NA | | | | | | |
| **A** | 7.0 | NA | | | | | |
| **B** | 9.0 | 10.0 | NA | | | | |
| **C** | 13.0 | 14.0 | 10.0 | NA | | | |
| **D** | 15.0 | 14.0 | 12.0 | 10.0 | NA | | |
| **E** | | | 14.0 | 14.0 | 10.0 | NA | |
| **F** | | | | 14.0 | 12.0 | 10.0 | NA |

In Table 2, a CPD value of 0 is used, and a distance of 15 is used for the lowest measurable signal between nodes. For example, the signal strength measurement in Table 1 between the analysis module in the distribution transformer (DT) 1102 and node D 1114 is zero. Accordingly, a distance of 15 is estimated. Likewise, the signal measured between node E 1108 and node F 1116 is 5, so a distance of 10 is estimated. Comparing these estimates with the actual distances of Figure 11, as shown in Table 1, indicates that while the actual distance between DT 1102 and node D 1114 is 15, the actual distance between node F 1116 and node E 1108 is 8, as opposed to the estimate of 10. This differential is caused by the CPD between node D1114, which is at phase 0 and node E1108, which is at phase 1. Note, however, that because the DT 1102 is coupled with all three phases, there is no CPD, and signal measurements with the DT 1102 correlate to distance without adjustment.

The lack of a CPD between the DT 1102 and each node allows a partial grid constructed based on the estimated distances between the DT 1102 and each node. For example, it can be determined that the values of table 2 using an estimated CPD value of zero are incorrect because of the internal inconsistency of the measurements. For example, if the distance between the DT 1102 and node A 1104 is 7.0, and the distance between the DT 1102 and node B is 9, the distance between node A 1104 and node B 1112 should be 8, as opposed to the 10 that is estimated using a CPD of 0. In one embodiment, a proper CPD value can then be determined by iterating through possible CPD values until a consistent grid is constructed. In one embodiment, a CPD value can be estimated by analyzing the delta between in phase and cross phase measurements.

Table 3 below shows a set of distance values estimated using a CPD of 2.

**Table 3: Computed Distances (CPD Value 2)**

| **Device** | **DT** | **A** | **B** | **C** | **D** | **E** | **F** |
|---|---|---|---|---|---|---|---|
| **DT** | NA | | | | | | |
| **A** | 7.0 | NA | | | | | |
| **B** | 9.0 | 8.0 | NA | | | | |
| **C** | 13.0 | 12.0 | 8.0 | NA | | | |
| **D** | 15.0 | 14.0 | 10.0 | 8.0 | NA | | |
| **E** | | | 14.0 | 12.0 | 8.0 | NA | |
| **F** | | | | 14.0 | 10.0 | 8.0 | NA |

Assuming a CPD value of 2 would result in the signal strength measurements shown in Table 2. The estimated distances between the distribution transformer DT 1102 and each node are unchanged. However, a cross phase delta of two is added for each cross phase signal strength measurement before distances are estimated. Accordingly, the estimated distance between node A 1104 at phase 0, and node B 1112 at phase 1 is reduced to 8.0, which is consistent with the distances estimated based between the DT 1102 and each node, or the various nodes which are in the same phase (e.g., node A 1104 and node D 1114).

Additional statements of invention are set out below.
Statement 1. A method, comprising:
   mapping a plurality of nodes to a virtual grid, the virtual grid being a representation of the nodes on a physical grid;
   assigning a sequence of metrics to each node on the virtual grid, the metrics comprising signal margin and failure history;
   performing statistical analysis of the metrics assigned to the nodes on the virtual grid; and
   detecting a failure on the physical grid, based upon the statistical analysis of the metrics assigned to the nodes on the virtual grid.
Statement 2. The method of statement 1, further comprising locating a failure on the physical grid based upon a statistical analysis of the virtual grid.
Statement 3. The method of statement 1 or 2, wherein mapping a plurality of nodes to a virtual grid further comprises:
   receiving one or more signal strength values measured between each of the plurality nodes on the physical grid;
   calculating a first length of a first virtual line originating from a virtual representation of a first node to a virtual representation of a second node, wherein the first length is proportional to the one or more signal strength values between the first node and the second node; and
   placing the first virtual line, the virtual representation of the first node, and the virtual representation of the second node on the virtual grid.
Statement 4. The method of statement 3, further comprising:
   calculating a second length of a second virtual line originating from a virtual representation of a second node to a first point on the first virtual line; and
   placing the second virtual line, the virtual representation of the second node, and the first point on the virtual grid;
Statement 5. The method of statement 4, further comprising:
   calculating a third length of a third virtual line originating from a virtual representation of a third node to a point on an existing virtual line; and
   placing the third virtual line, the virtual representation of the third smart meter, and the point on the virtual grid.
Statement 6. The method of statement 5 wherein calculating a third length comprises:
   computing a sum of the signal strength values between the first and third node, and the second and third node;
   computing a difference between the signal strength value between the first and second node and the sum; and
   assigning half of the numerical value of the difference to the third length.
Statement 7. The method of any preceding statement, wherein there is an inverse relationship between a length of a line on the virtual grid and a signal strength value on the physical grid.
Statement 8. The method of statement 7, wherein a signal value of no path indicates that no signal strength value has been received, and a signal value of unknown indicates that that no attempt has been made to measure a signal strength value.
Statement 9. The method of statement 7 or 8, wherein the mapping a plurality of nodes to a virtual grid further comprises representing a plurality of closely grouped nodes by a single virtual node on the virtual grid, the plurality of closely grouped nodes having signal strength value measurements between them being lower than a threshold value.
Statement 10. The method of any of statements 7 to 9, wherein the mapping of a plurality of nodes to a virtual grid further comprises adjusting the distance calculated via the signal strength between nodes to account for the cross phase delta of the signal measurements.
Statement 11. A system, comprising:
   at least one smart meter to connect to the physical grid, the smart meter comprising a smart meter module, a signal strength module, and a communications module; and
   a distribution transformer, to connect the physical grid, the distribution transformer comprising, a power meter module, a signal strength measurement module, a power line communications module, and an analysis module, wherein the distribution transformer is configured to:
      map a plurality of smart meters to a virtual grid based upon a plurality of signal strength values received from the plurality of smart meters, the virtual grid being a representation of the physical grid; and
      determine if a failure has occurred on the physical grid, based upon information from the analysis module and mapping information obtained from the virtual grid.
Statement 12. The system of statement 11, wherein the distribution transformer is further configured to determine the location of the failure on the physical grid via information from the analysis module and mapping information from the virtual grid.
Statement 13. The system of statement 11 or 12, wherein the analysis module comprises an event analysis module, a storage module, and at least one of a signal-measuring module and energy use module, and failure analysis module.
Statement 14. The system of statement 13, wherein the signal-measuring analysis module implements a method comprising determining a difference between the plurality of signal strength values relative to a noise measurement; and comparing the difference to historical data.
Statement 15. The system of statement 13, wherein the signal-measuring analysis module implements a method comprising adjusting a set of distance calculations determined via signal measurements to account for cross-phase delta between nodes having different alternating current phases.
Statement 16. The system of statement 13, wherein the energy monitoring analysis module implements a method comprising detecting a change in total energy use measured at a distribution transformer via the power meter module, comparing the change in total energy use with a measurement of historical energy usage trends, and correlating the change in total energy use with a loss of communication with the power line communications module of the distribution transformer.
Statement 17. The system of any of statements 13 to 16, wherein the failure analysis module analyzes a failure history record of a smart meter, which has experienced the communication failure.
Statement 18. The system of statement 17, wherein the failure analysis module detects if a smart meter is able to send information but is unable to receive a response by analyzing a set of communication statistics with the smart meter.
Statement 19. The system of statement 18, wherein the failure analysis module detects multiple concurrent failures located near a common point in the power grid.
Statement 20. The system of statement 19, wherein the failure analysis module predicts if a plurality of external factors could cause a failure, wherein the plurality of external factors are received externally to the module.
Statement 21. The system of any of statements 13 to 20, wherein the at least one smart meter further comprises a communication failure alert module to send a periodic signal to the distribution transformer; and wherein the distribution transformer is further configured to receive the periodic signal.
Statement 22. The system of any of statements 17 to 20, wherein the at least one smart meter further comprises a last gasp module to send a signal to the distribution transformer upon detecting a failure; and wherein the distribution transformer is further configured to receive the signal.
Statement 23. The system of any of statements 11 to 22, wherein the at least one smart meter further comprises a noise detection module to send a signal to the distribution transfomer when noise is detected; and wherein the distribution transformer is further configured to receive the signal.
Statement 24. The system of statement 13, wherein the storage module is configured to store historical communications statistics for a plurality of objects located on the physical grid. Statement 25. The system of statement 24, wherein the physical grid is configured using the historical communications statistics.
Statement 26. A distribution transformer apparatus, comprising:
   an input output module connected to an external power line;
   a power line communications module connected to the input output module;
   a power meter module connected to the input output module, and operative to measure the amount of electrical energy being used by a plurality of consumers downstream of the transformer;
   a signal measurement module connected to the power line communications module; and an analysis module to:
      map a plurality of objects on a connected physical grid to a representative virtual grid based upon a plurality of signal strength measurements between the plurality of objects, wherein the plurality of signal strength measurements are received by the distribution transformer via power line communications; and to
      determine if a failure has occurred on the physical grid, based upon information from an analysis module and information from the virtual grid, wherein the failure is selected from the group consisting of a physical outage and a communication failure.
Statement 27. The distribution transformer of statement 26, wherein the analysis module is further operative to: determine at what location the failure has occurred on the physical grid, based upon information from the analysis module and information obtained from the virtual grid.
Statement 28. The distribution transformer of statement 26 or 27, wherein the analysis module is further operative to adjust the plurality of signal strength measurements based on a cross-phase delta, wherein the cross phase delta causes a variance in signal strength measurements between two meters which carry alternating current of differing phase.
Statement 29. A method of mapping a plurality of nodes of a multi-phase electrical power distribution grid onto a virtual grid, the method comprising:
   measuring a signal strength metric between each node of the plurality of nodes, wherein the nodes have differing phases of electrical power.
   calculating a cross phase delta between nodes in the plurality of nodes having differing phases;
   adjusting the signal strength metric between the nodes having differing phases using the cross phase delta; and
   estimating a set of distances between multiple nodes in the plurality of nodes using the adjusted signal strength metric for nodes having differing phases.
Statement 30. The method of statement 29, wherein adjusting the signal strength metric between the nodes having differing phases includes adding the cross phase delta to the signal strength metric between nodes having differing phases.
Statement 31. The method as in statement 29 or 30, wherein calculating the cross phase delta between nodes having differing phases comprises:
   estimating a distance between a subset of the plurality of nodes having differing phases using a value from a set of possible cross phase delta values, to map the subset onto the grid;
   estimating a distance between a subset of the plurality of nodes having the same phase, to map the subset onto the grid; and
   determining the cross phase delta by comparing the estimated distance between nodes having the same phase with the estimated distance between nodes having differing phases.
Statement 32. The method as in claim 31, wherein estimating a distance between a subset of the plurality of nodes having differing phases includes iterating through each possible cross phase delta values, and estimating a distance using each value.
Statement 33. The method of statement 30, wherein calculating the cross phase delta between nodes comprises:
   estimating a distance between a subset of the plurality of nodes having differing phases using a cross phase delta value of zero;
   estimating a distance between a subset of the plurality of nodes having the same phase; and
   determining a possible cross phase delta by comparing the estimated distance between the subset of the plurality of nodes having differing phases with the estimated distance between the subset of the plurality of nodes having the same phase.

Various components described above are used as a means for performing the operations or functions described. Each component described herein is constructed from hardware components, or hardware components supplemented with software instructions. Additionally, some components are constructed using embedded controllers and hardwired circuitry. Besides what is described herein, various modifications can be made to the disclosed embodiments and implementations of the invention without departing from their scope, therefore, the illustrations and examples herein should be construed in an illustrative, and not a restrictive sense.

## Claims

1. A method, comprising:
mapping a plurality of nodes to a virtual grid, the virtual grid being a representation of the nodes on a physical grid;
assigning a sequence of metrics to each node on the virtual grid, the metrics comprising signal margin and failure history;
performing statistical analysis of the metrics assigned to the nodes on the virtual grid; and
detecting a failure on the physical grid, based upon the statistical analysis of the metrics assigned to the nodes on the virtual grid.

2. The method of claim 1, further comprising locating a failure on the physical grid based upon a statistical analysis of the virtual grid.

3. The method of claims 1 or 2, wherein mapping a plurality of nodes to a virtual grid further comprises:
receiving one or more signal strength values measured between each of the plurality nodes on the physical grid;
calculating a first length of a first virtual line originating from a virtual representation of a first node to a virtual representation of a second node, wherein the first length is proportional to the one or more signal strength values between the first node and the second node; and
placing the first virtual line, the virtual representation of the first node, and the virtual representation of the second node on the virtual grid.

4. The method of any of claims 1 to 3, wherein there is an inverse relationship between a length of a line on the virtual grid and a signal strength value on the physical grid.

5. The method of claim 4, wherein a signal value of no path indicates that no signal strength value has been received, and a signal value of unknown indicates that that no attempt has been made to measure a signal strength value.

6. The method of any of claims 1 to 5, wherein the mapping a plurality of nodes to a virtual grid further comprises representing a plurality of closely grouped nodes by a single virtual node on the virtual grid, the plurality of closely grouped nodes having signal strength value measurements between them being lower than a threshold value.

7. The method of any of claims 1 to 6, wherein the mapping of a plurality of nodes to a virtual grid further comprises adjusting the distance calculated via the signal strength between nodes to account for the cross phase delta of the signal measurements.

8. A system, comprising:
at least one smart meter to connect to the physical grid, the smart meter comprising a smart meter module, a signal strength module, and a communications module; and
a distribution transformer, to connect the physical grid, the distribution transformer comprising, a power meter module, a signal strength measurement module, a power line communications module, and an analysis module, wherein the distribution transformer is configured to:
map a plurality of smart meters to a virtual grid based upon a plurality of signal strength values received from the plurality of smart meters, the virtual grid being a representation of the physical grid; and
determine if a failure has occurred on the physical grid, based upon information from the analysis module and mapping information obtained from the virtual grid.

9. The system of claim 8, wherein the failure analysis module to analyze a failure history record of a smart meter, which has experienced the communication failure.

10. The system of claim 8 or 9, wherein the failure analysis module to detect if a smart meter is able to send information but is unable to receive a response by analyzing a set of communication statistics with the smart meter.

11. The system of any of claims 8 to 10, wherein the at least one smart meter further comprises a communication failure alert module to send a periodic signal to the distribution transformer; and wherein the distribution transformer is further configured to receive the periodic signal.

12. The system of any of claims 8 to 11, wherein the at least one smart meter further comprises a last gasp module to send a signal to the distribution transformer upon detecting a failure; and wherein the distribution transformer is further configured to receive the signal.

13. A distribution transformer apparatus, comprising:
an input output module connected to an external power line;
a power line communications module connected to the input output module;
a power meter module connected to the input output module, and operative to measure the amount of electrical energy being used by a plurality of consumers downstream of the transformer;
a signal measurement module connected to the power line communications module; and an analysis module to:
map a plurality of objects on a connected physical grid to a representative virtual grid based upon a plurality of signal strength measurements between the plurality of objects, wherein the plurality of signal strength measurements are received by the distribution transformer via power line communications; and to
determine if a failure has occurred on the physical grid, based upon information from an analysis module and information from the virtual grid, wherein the failure is selected from the group consisting of a physical outage and a communication failure.

14. The distribution transformer of claim 13, wherein the analysis module is further operative to:
determine at what location the failure has occurred on the physical grid, based upon information from the analysis module and information obtained from the virtual grid.

15. The distribution transformer of claim 13 or 14, wherein the analysis module is further operative to adjust the plurality of signal strength measurements based on a cross-phase delta, wherein the cross phase delta causes a variance in signal strength measurements between two meters which carry alternating current of differing phase.
